# EUROPEAN PATENT APPLICATION

(11) **EP 4 531 523 A1**
(43) Date of publication of application: **02.04.2025**
(21) Application number: 22947639.5
(22) Date of filing: 28.09.2022
(51) Int. Cl.: H10K 59/10

(54) **DISPLAY PANEL AND DISPLAY APPARATUS**

(30) Priority: 24.06.2022 CN 202210724607
(71) Applicant: Kunshan Go-Visionox Opto-Electronics Co., Ltd., KunShan, Jiangsu 215300 (CN)
(72) Inventor: DENG, Xianzhu, Kunshan, Jiangsu 215300 (CN); ZHANG, Meng, Kunshan, Jiangsu 215300 (CN); DU, Lingxiao, Kunshan, Jiangsu 215300 (CN); SHAO, Yang, Kunshan, Jiangsu 215300 (CN)
(74) Representative: Arnold & Siedsma
(86) International application number: PCT/CN2022/122288
(87) International publication number: WO 2023/245899

(57) **Abstract**

Disclosed are a display panel and a display apparatus. The display panel includes a light-emitting area and a non-light-emitting area. The display panel includes a light-emitting side and a backlight side oppositely arranged along a thickness direction of the display panel. The display panel includes a touch control layer and a light filtering layer. The light filtering layer includes a light-shielding layer and a plurality of color resistances located in the touch control layer, and at least part of the plurality of color resistances are located in the light-emitting area. The light-shielding layer is located on a side, facing the light-emitting side, of the touch control layer and is located in the non-light-emitting area. Structure layers in the touch control layer may prevent water and oxygen from corroding the color resistance, so that protection for the color resistance may be formed and there is no need to arrange a barrier layer separately for the color resistance, thereby simplifying the preparation process of the display panel and the display apparatus. Therefore, according to the display panel and the display apparatus provided in the present application, the preparation process of the display panel and the display apparatus may be simplified.

## Description

This application claims priority to Chinese Patent Application No. 202210724607.9, which was filed with China National Intellectual Property Administration on June 24, 2022 and titled "Display Panel and Display apparatus". The disclosure of the above patent application is incorporated herein by reference in its entirety.

### TECHNICAL FIELD

The present application relates to the field of display panel technologies and, in particular, to a display panel and a display apparatus.

### BACKGROUND

An Organic Light-Emitting Diode (OLED) has characteristics of active light emission, high contrast, ultra-thin thickness, low temperature resistance, fast response speed, low power consumption, wide viewing angle, strong shock resistance, etc., and thus has been applied increasingly.

In the related arts, a display panel includes a light-emitting area and a non-light-emitting area adjacent to the light-emitting area. The display panel includes a touch control layer and a light filtering layer located on the touch control layer. The light filtering layer includes a color resistance layer and a light-shielding layer surrounding the color resistance layer, where the color resistance layer is located in the light-emitting area, and the light-shielding layer is located in the non-light-emitting area.

However, preparation processes of the above-mentioned display panel are relatively complicated.

### SUMMARY

In view of at least one of the above-mentioned technical problems, embodiments of the present application provide a display panel and a display apparatus, which can simplify the preparation process of the display panel and the display apparatus.

In order to achieve the above object, embodiments of the present application provide the following technical solutions.

In a first aspect, an embodiment of the present application provides a display panel, including a light-emitting area and a non-light-emitting area. The display panel includes a light-emitting side and a backlight side oppositely arranged along a thickness direction of the display panel. The display panel includes a touch control layer and a light filtering layer, where the light filtering layer includes a light-shielding layer and a plurality of color resistances, the plurality of color resistances are located in the touch control layer, at least part of the plurality of color resistances are located in the light-emitting area; the light-shielding layer is located on a side, facing the light-emitting side, of the touch control layer and is located in the non-light-emitting area.

According to the display panel provided in the embodiment of the present application, the display panel may include the light-emitting area and thenon-light-emitting area, and the light-emitting area and the non-light-emitting area may be arranged adjacently. The display panel includes the light-emitting side and the backlight side oppositely arranged along the thickness direction of the display panel. The display panel includes a touch control layer and a light filtering layer, and the light filtering layer is configured to reduce reflection of ambient light, thereby improving display effect of the display panel. The light filtering layer includes a light-shielding layer and a plurality of color resistances, and the plurality of color resistances are located in the touch control layer. At least part of the plurality of color resistances are located in the light-emitting area, so that structure layer(s) in the touch control layer (for example, a first insulating layer and/or a second insulating layer) can prevent water and oxygen from corroding the color resistance, thereby forming protection for the plurality of color resistances. It is not necessary to separately provide a barrier layer for the color resistance, so that the preparation processes of the display panel and the display apparatus can be simplified. The light-shielding layer is located on the side, facing the light-emitting side, of the touch control layer and is located in the non-light-emitting area, so that the light-shielding layer can absorb the light irradiated on the light-shielding layer, thereby reducing ambient reflected light.

In a possible implementation, the touch control layer includes a first touch control wire and a second touch control wire, and the second touch control wire is located on a side, facing the light-emitting side, of the first touch control wire.

In a possible implementation, an orthographic projection of the light-shielding layer on a plane where the first touch control wire is located covers the first touch control wire; and/or an orthographic projection of the light-shielding layer on a plane where the second touch control wire is located covers the second touch control wire.

In a possible implementation, at least part of the plurality of color resistances extend to the non-light-emitting area, and an orthographic projection of the color resistance located in the non-light-emitting area on a plane where the light-shielding layer is located at least partially overlaps the light-shielding layer.

In this way, the light-shielding layer can better prevent the reflection of ambient light and ensure the display effect of the display panel and the display apparatus.

In a possible implementation, the plurality of color resistances include a first color resistance arranged in a same layer as the first touch control wire.

In a possible implementation, a surface, facing the light-emitting side, of the first color resistance is flush with or protrudes from a surface, facing the light-emitting side, of the first touch control wire.

In this way, the first color resistance can prevent the reflection of ambient light and ensure the display effect of the display panel and the display apparatus.

In a possible implementation, the display panel further includes an encapsulation layer, and the encapsulation layer is located on a side, facing away from the light-shielding layer, of the touch control layer and is contacted with the first color resistance.

In this way, it is advantageous to reduce the thickness of the display panel.

In a possible implementation, the display panel further includes a light-emitting layer. The light-emitting layer is located on a side, facing away from the light-shielding layer, of the encapsulation layer and includes an anode layer, a pixel layer and a cathode layer stacked along the thickness direction. The anode layer is located on a side, facing away from the light-shielding layer, of the pixel layer,, and the pixel layer is located in the light-emitting area. The anode layer includes a plurality of anodes, and the pixel layer includes a plurality of pixels.

In a possible implementation, a shape of at least one of the anode and the pixel includes a circle.

In a possible implementation, the light-emitting layer further includes a pixel defining layer, and the pixel defining layer is located between the anode layer and the cathode layer. The pixel defining layer is defined with a plurality of first openings, and the plurality of pixels are located at the first openings. An orthographic projection of the pixel defining layer on a plane where the plurality of anodes are located covers edges of the plurality of anodes, and a shape of the first opening includes a circle; and/or the light-shielding layer is defined with a plurality of second openings, an orthographic projection of the second openings on the light-emitting layer covers the pixel layer, and a shape of the second opening includes a circle.

In a possible implementation, the plurality of color resistances include a second color resistance arranged in a same layer as the second touch control wire.

In a possible implementation, a surface, facing the light-emitting side, of the second color resistance is flush with or protrudes from a surface, facing the light-emitting side, of the second touch control wire.

In this way, the second color resistance can prevent the reflection of ambient light and ensure the display effect of the display panel and the display apparatus.

In a possible implementation, the display panel further includes a first auxiliary color resistance located in the touch control layer. The first auxiliary color resistance and the first touch control wire are arranged in different layers, and the first auxiliary color resistance and the second touch control wire are arranged in different layers. The first auxiliary color resistance is located on at least one of a surface, facing the light-emitting side, of the first touch control wire and a surface, facing the backlight side, of the first touch control wire; and/or, the first auxiliary color resistance is located on at least one of a surface, facing the light-emitting side, of the second touch control wire and a surface, facing the backlight side, of the second touch control wire.

In this way, the first auxiliary color resistance can form protection for the first touch control wire and/or the second touch control wire.

In a possible implementation, the display panel further includes a second auxiliary color resistance located in the touch control layer. The second auxiliary color resistance is located on a side, facing the light-emitting area, of the non-light-emitting area, and the second auxiliary color resistance has different color from a color resistance of the plurality of the color resistances adjacent thereto.

In a possible implementation, the display panel includes a display area and a non-display area, and the light-emitting area and the non-light-emitting area are located in the display area. The light-shielding layer includes a first light-shielding layer and a second light-shielding layer, the first light-shielding layer is located in the display area, and the second light-shielding layer is located in the non-display area.

In this way, the second light-shielding layer is beneficial to the sealing property of the display panel.

In a second aspect, an embodiment of the present application provides a display apparatus, including the display panel according to the first aspect.

According to the display apparatus provided in the embodiments of the present application, the display apparatus can include a display panel, and the display panel may include the light-emitting area and the non-light-emitting area. The light-emitting area and the non-light-emitting area may be arranged adjacently. The display panel includes the light-emitting side and the backlight side oppositely arranged along the thickness direction of the display panel. The display panel includes a touch control layer and a light filtering layer, and the light filtering layer is configured to reduce the reflection of ambient light, thereby improving the display effect of the display panel. The light filtering layer includes a light-shielding layer and a plurality of color resistances, and the plurality of color resistances are located in the touch control layer. At least part of the plurality of color resistances are located in the light-emitting area, and the structure layer(s) in the touch control layer (for example, a first insulating layer and/or a second insulating layer) can prevent water and oxygen from corroding the color resistance, so as to form protection for the color resistance. It is not necessary to separately provide a barrier layer for the color resistance, so that the preparation processes of the display panel and the display apparatus can be simplified. The light-shielding layer is located on the side, facing the light-emitting side, of the touch control layer, and is located in the non-light-emitting area, so that the light-shielding layer can absorb the light irradiated on the light-shielding layer, thereby reducing ambient reflected light.

The configuration of the present application and other inventive objects and beneficial effects thereof will be more clearly understood from the description of the embodiments in conjunction with the accompanying drawings.

### BRIEF DESCRIPTION OF DRAWINGS

In order to more clearly illustrate the embodiments of the present application or the technical solutions in the prior art, the following briefly introduces the accompanying drawings that need to be used in the description of the embodiments or the prior art. Obviously, the accompanying drawings in the following description are intended for some embodiments of the present application. For those skilled in the art, other drawings can also be obtained based on these drawings without any creative effort.
FIG. 1 is a schematic structural diagram of a display panel provided by an embodiment of the present application.
FIG. 2 is a schematic structural diagram of a first color resistance provided by an embodiment of the present application.
FIG. 3 is another schematic structural diagram of a first color resistance provided by an embodiment of the present application.
FIG. 4 is still another schematic structural diagram of a first color resistance provided by an embodiment of the present application.
FIG. 5 is yet still another schematic structural diagram of a first color resistance provided by an embodiment of the present application.
FIG. 6 is a schematic structural diagram of a second color resistance provided by an embodiment of the present application.
FIG. 7 is another schematic structural diagram of a second color resistance provided by an embodiment of the present application.
FIG. 8 is a schematic structural diagram of a first auxiliary color resistance provided by an embodiment of the present application.
FIG. 9 is another schematic structural diagram of a first auxiliary color resistance provided by an embodiment of the present application.
FIG. 10 is still another schematic structural diagram of a first auxiliary color resistance provided by an embodiment of the present application.
FIG. 11 is a schematic structural diagram of a second auxiliary color resistance provided by an embodiment of the present application.

### DESCRIPTION OF EMBODIMENTS

In the related art, a display panel includes a light-emitting area and a non-light-emitting area adjacent to the light-emitting area. The display panel includes a touch control layer and a light filtering layer on the touch control layer. The light filtering layer includes a color resistance layer and a light-shielding layer, where the color resistance layer is located in the light-emitting area, and the light-shielding layer is located in the non-light-emitting area. The touch control layer includes a first touch control wire, a first insulating layer, a second touch control wire and a second insulating layer that are stacked in sequence. Both the first touch control wire and the second touch control wire are located in the non-light-emitting area, and both the first insulating layer and the second insulating layer are located in the light-emitting area and the non-light-emitting area.

However, since the color resistance layer is formed of organic materials, it is easy to be corroded by water and oxygen, so it is necessary to arrange a barrier layer on a side, facing away from the touch control layer, of the color resistance layer to form protection for the color resistance layer, thereby preventing water and oxygen from corroding the color resistance layer. As a result, the preparation processes of the display panel and the display apparatus are complicated.

Based on at least one of the above technical problems, embodiments of the present application provide a display panel and a display apparatus. The display panel may include a light-emitting area and a non-light-emitting area, and the light-emitting area and the non-light-emitting area may be arranged adjacent to each other. The display panel includes a light-emitting side and a backlight side arranged oppositely in a thickness direction of the display panel. The display panel includes a touch control layer and a light filtering layer, and the light filtering layer is used to reduce the reflection of ambient light, thereby improving the display effect of the display panel. The light filtering layer includes a light-shielding layer and a plurality of color resistances, and the plurality of color resistances are located in the touch control layer. At least part of the plurality of color resistances are located in the light-emitting area, and structure layer(s) in the touch control layer (for example, the above-mentioned first insulating layer and/or second insulating layer) can prevent water and oxygen from corroding the color resistance, thereby forming protection for the color resistance. It is not necessary to separately provide a barrier layer for the color resistance, so that the preparation processes of the display panel and the display apparatus can be simplified. The light-shielding layer is located on the side, facing the light-emitting side, of the touch control layer, and is located in the non-light-emitting area, so that the light-shielding layer can absorb the light irradiated on the light-shielding layer, thereby reducing ambient reflected light.

In order to make the objects, technical solutions and advantages of the embodiments of the present application clearer, the technical solutions in the embodiments of the present application will be described clearly and comprehensively below with reference to the accompanying drawings in the embodiments of the present application. Obviously, the described embodiments are some of the embodiments of the present application, but not all of the embodiments. Based on the embodiments in the present application, all other embodiments obtained by those of ordinary skill in the art without creative work fall within the protection scope of the present application.

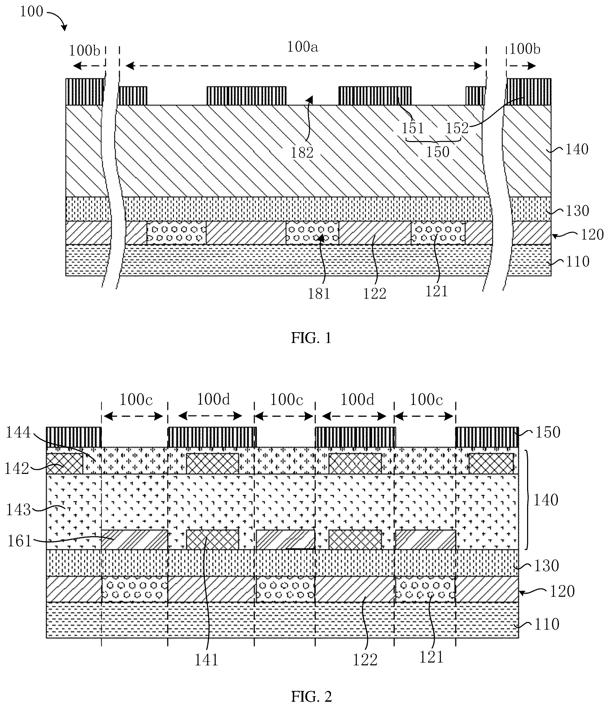

The display apparatus provided by the embodiments of the present application will be described below with reference to FIGS. 1 to 11.

The present embodiment provides a display apparatus including a display panel 100. The display apparatus may be a mobile or stationary terminal with the display panel 100, such as an electronic paper, a mobile phone, a tablet computer, a television, a display, a notebook computer, a digital photo frame, a smart bracelet, smart watch, a personal super computer, a navigator, etc.

The display panel 100 may be an Organic Light-Emitting Diode (OLED) display panel, a Micro Light-Emitting Diode (Micro LED or µ LED) display panel, or a Liquid Crystal Display (LCD) display panel.

The display panel 100 provided by embodiments of the present application are described by taking an OLED display panel as an example.

The display panel 100 provided by the embodiments of the present application will be described below.

The present embodiment provides a display panel 100, and the display panel 100 may be applied to the above-mentioned display apparatus.

The display panel 100 may include a light-emitting side and a backlight side arranged oppositely along a thickness direction of the display panel 100. The light-emitting side is a side for displaying an image, and the backlight side is another side opposite to the light-emitting side along the thickness direction of the display panel 100.

As shown in FIG. 1, the display panel 100 may include an array substrate 110 and a light-emitting layer 120 on the array substrate 110. The array substrate 110 is provided with a plurality of driving units, and the plurality of driving units may be arranged in an array. The driving units are electrically connected to the light-emitting layer 120 and configured to provide driving current for the light-emitting layer 120. A driving unit may include a Thin Film Transistor (TFT) and a capacitor structure. For example, the thin film transistor may include at least one of a Metal Oxide (MO) thin film transistor and a Low Temperature Poly-silicon (LTPS) thin film transistor.

The light-emitting layer 120 provided by the embodiments of the present application will be described in the following.

The light-emitting layer 120 may include an anode layer and a cathode layer, and the anode layer is located on a side, facing the array substrate 110, of the cathode layer. The anode layer may be a pixel electrode, and the cathode layer may be a common electrode. The anode layer may include a plurality of anodes spaced apart, and a shape of the anode may be a circle. Of course, the shape of the anode may also be any one or more of an ellipse and a polygon (such as a quadrilateral, a pentagon, a hexagon, etc.). It has many choices and can be applied to many scenarios.

As shown in FIG. 1, the light-emitting layer 120 may include a pixel layer 121 and a pixel defining layer 122. The pixel layer 121 is formed of a light-emitting material, and the pixel layer 121 and the pixel defining layer 122 are located between the anode layer and the cathode layer. The pixel layer 121 generally includes a plurality of pixels, the plurality of pixels may be arranged in an array, and the plurality of pixels may include, but are not limited to, a red pixel, a green pixel and a blue pixel. In other examples, the plurality of pixels may also include a white pixel. The pixel defining layer 122 is located between two adjacent pixels, and the pixel defining layer 122 may be arranged around the periphery of the pixels. For example, a shape of the pixel can be a circle, and of course, the shape of the pixel can also be any one or more of an ellipse and a polygon (such as a quadrilateral, a pentagon, a hexagon, etc.). It has many choices and can be applied to many scenarios.

As shown in FIG. 1, the pixel defining layer 122 has a plurality of first openings 181 spaced apart. The first openings 181 are configured to arrange pixels, and the plurality of pixels may be deposited in the first openings 181. An orthographic projection of the pixel defining layer 122 on the plane where the plurality of anodes are located covers edges of the plurality of anodes. For example, a shape of the first opening 181 may be a circle. Of course, the shape of the first opening 181 may also be any one or more of an ellipse and a polygon (such as a quadrilateral, a pentagon, a hexagon, etc.). It has many choices and can be applied to many scenarios.

The light-emitting layer 120 may further include at least one of a hole injection layer, a hole transport layer, an electron blocking layer, a hole blocking layer, an electron transport layer, and an electron injection layer.

It can be understood that, as shown in FIG. 1, the display panel 100 may include a display area 100a and a non-display area 100b, the display area 100a is configured to display an image, and the non-display area 100b is arranged adjacent to the display area 100a. The non-display area 100b is located on at least one side of the display area 100a. For example, the non-display area 100b may be provided around the outer periphery of the display area 100a.

As shown in FIG. 2, the display area 100a may include a light-emitting area 100c and a non-light-emitting area 100d. The light-emitting area 100c corresponds to a pixel, and the pixel is located in the light-emitting area 100c. For example, the light-emitting area 100c may coincide with the pixel. In addition, the non-light-emitting area 100d is arranged between adjacent light-emitting areas 100c, and the non-light-emitting area 100d may be arranged around the periphery of the light-emitting area 100c. The non-light-emitting area 100d may correspond to at least part of the pixel defining layer 122.

As shown in FIG. 1, the display panel 100 may further include an encapsulation layer 130. The encapsulation layer 130 is located on a side, facing away from the array substrate 110, of the light-emitting layer 120. The encapsulation layer 130 is configured to seal the light-emitting layer 120 so as to avoid damage to the display panel 100 due to penetration of outside water and oxygen into the light-emitting layer 120 and the driving units.

Exemplarily, the encapsulation layer 130 may adopt technology of Thin Film Encapsulation (TFE). A TFE encapsulation layer may include a plurality of sub encapsulation film layers, and a multi-layer stacked structure in which an inorganic layer/an organic layer/an inorganic layer are alternately stacked may be adopted. Therein, the inorganic layers are configured to effectively block water and oxygen, and the organic layer is configured to buffer stress in the inorganic layers.

As shown in FIG. 1, the display panel 100 may further include a touch control layer 140. The touch control layer 140 is located on a side, facing away from the array substrate 110, of the encapsulation layer 130, and the touch control layer 140 is configured to implement a touch control function.

Exemplarily, a buffer layer may be arranged between the touch control layer 140 and the encapsulation layer 130, and the buffer layer may be formed of an inorganic material (e.g., silicon nitride, silicon oxide, etc.) or an organic material. Of course, the touch control layer 140 may be directly arranged on the encapsulation layer 130 without providing a buffer layer, so as to facilitate the lightening and thinning of the display panel 100. An embodiment of the present application will be described by taking an example where the touch control layer 140 is in direct contact with the encapsulation layer 130.

The touch control layer 140 provided in the embodiments of the present application will be described below.

As shown in FIG. 2, the touch control layer 140 may include a first touch control wire 141 and a second touch control wire 142, and the second touch control wire 142 is located on a side, facing the light-emitting side, of the first touch control wire 141. That is, the second touch control wire 142 is located on a side, facing away from the light-emitting layer 120, of the first touch control wire 141.

In the touch control layer 140, one of the first touch control wire 141 and the second touch control wire 142 is a bridge layer, and the other of the first touch control wire 141 and the second touch control wire 142 may be a touch control function layer. The touch control function layer may include a plurality of first touch control electrodes extending along a first direction, and a plurality of second touch control electrodes extending along a second direction. The first direction and the second direction are different. For example, the first direction may be a length direction of the display panel 100, and the second direction may be a width direction of the display panel 100.

The length, width and thickness described in the embodiments of the present application are only for the convenience of description and do not imply any limitation on the size. For example, the length can be greater than, equal to, or less than the width.

Exemplarily, one of the first touch control electrode and the second touch control electrode is a driving electrode, and the other of the first touch control electrode and the second touch control electrode is a sensing electrode. It should be noted that although the driving electrode and the sensing electrode are both formed by the first touch control wire 141 or the second touch control wire 142, they are insulated from each other. One of the driving electrode and the sensing electrode is a continuous and uninterrupted structure along the first direction (or the second direction), and the other one of the driving electrode and the sensing electrode includes a plurality of substructures spaced apart along the second direction (or the first direction) and bridged by the bridge layer.

Exemplarily, the first touch control wire 141 and the second touch control wire 142 may both be located in the non-light-emitting area 100d, so as to avoid affecting an aperture ratio of the display panel 100.

Exemplarily, the first touch control wire 141 and the second touch control wire 142 may be formed by a single-layer conductive layer, or may be a stacked structure of a multi-layer conductive layer.

In some embodiments, as shown in FIG. 2, the touch control layer 140 may include a first insulating layer 143 located between the first touch control wire 141 and the second touch control wire 142 and is configured to electrically isolate the first touch control wire 141 and the second touch control wire 142. In addition, the touch control layer 140 may further include a second insulating layer 144 located on a side, facing away from the light-emitting layer 120, of the second touch control wire 142, and is configured to protect the first touch control wire 141 and the second touch control wire 142.

The display panel 100 may include a light filtering layer, configured to reduce the reflection of ambient light, thereby improving the display effect of the display panel 100.

The light filtering layer provided in the embodiments of the present application will be described below.

The light filtering layer may include a plurality of color resistances, and the plurality of color resistances may be configured to filter light of a different color from its own in ambient light. The color resistance can be formed of an organic material, which has high flexibility and is beneficial to the bending performance of the display panel 100.

The color resistance can be integrated in the touch control layer 140, and structure layers in the touch control layer 140, such as the first insulating layer 143 and/or the second insulating layer 144, can form protection for the color resistance, so that there is no need to separately provide a barrier layer for the color resistance, thereby simplifying the preparation processes of the display panel 100 and the display apparatus.

It can be understood that the distance between the color resistance and the light-emitting layer 120 may affect a filtering effect of the color resistance on a corresponding color light. When the distance between the color resistance and the light-emitting layer 120 in the thickness direction is too large, the light emitted by the pixel diffuses laterally at a high degree, so that the amount of light emitted from the color resistance corresponding to the pixel will be reduced, resulting in a poor display angle and inferior display brightness of the display panel 100 and the display apparatus. If the color resistance is integrated into the touch control layer 140, the color resistance is close to the pixel, and the amount of light emitted from the corresponding color resistance of the pixel will be increased, thereby improving the display angle and display brightness of the display panel 100 and the display apparatus.

At least part of the plurality of color resistances are located in the light-emitting area 100c. Color resistances located in the same layer may include a plurality of sub color resistances, and the plurality of sub color resistances are arranged in a one-to-one correspondence with the pixels. An orthographic projection of the sub color resistance on the light-emitting layer 120 covers the corresponding pixel and the sub color resistance has the same color as the pixel covered thereby, so as to avoid occurrence of mixed light. The plurality of sub color resistances may include any one or more of a red sub color resistance, a green sub color resistance, a blue sub color resistance, and a white sub color resistance. For example, a sub color resistance corresponding to a red pixel is the red sub color resistance. The red sub color resistance can block the light emitted by a blue pixel and a green pixel, and allow the red light emitted by the red pixel or the white pixel to pass through.

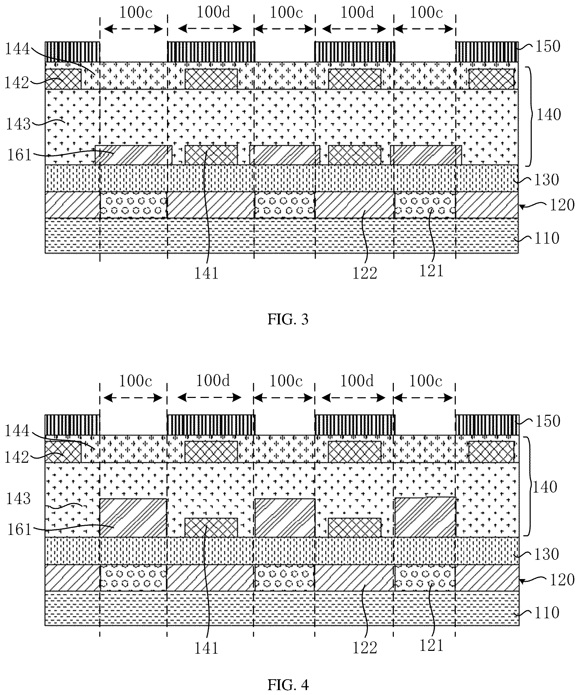

A size of the sub color resistance is greater than or equal to a size of the pixel, and an orthographic projection of the sub color resistance on the light-emitting layer 120 may cover the corresponding pixel. In some examples, the orthographic projection of the sub color resistance on the light-emitting layer 120 may coincide with the pixel. In this case, the sub color resistance has a same size as the corresponding pixel (e.g., the first color resistance 161 in FIG. 2). In other examples, the orthographic projection of the sub color resistance on the light-emitting layer 120 may cover the pixel, and there is a distance between an outer edge of the orthographic projection of the sub color resistance on the light-emitting layer 120 and an outer edge of the pixel. In this case, the size of the sub color resistance is larger than that of the corresponding pixel, so that the amount of light emitted from the sub color resistance corresponding to the pixel will increase (for example, the first color resistance 161 in FIG. 3).

A shape of the sub color resistance may be a circle, of course, the shape of the sub color resistance may also be any one or more of an ellipse and a polygon (such as a quadrilateral, a pentagon, a hexagon, etc.). It has many choices and can be applied to many scenarios.

As shown in FIG. 2, the plurality of color resistances may include a first color resistance 161, and the first color resistance 161 and the first touch control wire 141 are arranged in a same layer. The "same-layer-arrangement" of the first color resistance 161 and the first touch control wire 141 means that the first touch control wire 141 and the first color resistance 161 are prepared on a surface of the same side of the same basic structure layer along the thickness direction. For example, the first touch control wires 141 and the first color resistance 161 may be both arranged on a surface of a side, facing away from the light-emitting layer 120, of the encapsulation layer 130. The same-layer-arrangement in the embodiments of the present application has similar principles, and details are not repeated hereafter.

The first color resistance 161 provided in the embodiment of the present application will be described below.

The first color resistance 161 includes a plurality of sub color resistances arranged in a same layer, and one of the plurality of sub color resistances may be a first sub color resistance, the principle of which has already been described, and will not be repeated here.

Exemplarily, the first color resistance 161 and the first touch control wire 141 may be directly prepared on the encapsulation layer 130. At this time, both the first color resistance 161 and the first touch control wire 141 are in contact with the encapsulation layer 130. The distance between the color resistance 161 and the light-emitting layer 120 is relatively short, which can better ensure the display angle and display brightness of the display panel 100 and the display apparatus.

Exemplarily, as shown in FIG. 3, the surface, facing the light-emitting side, of the first color resistance 161 may be flush with the surface, facing the light-emitting side, of the first touch control wire 141, so that the surface of a side, facing away from the light-emitting layer, of the first color resistance 161 and the first touch control wire 141 is relatively flat. Alternatively, as shown in FIG. 4, the surface, facing the light-emitting side, of the first color resistance 161 may be raised relative to the surface, facing the light-emitting side, of the first touch control wire 141, which is beneficial to prevent light mixing of adjacent pixels.

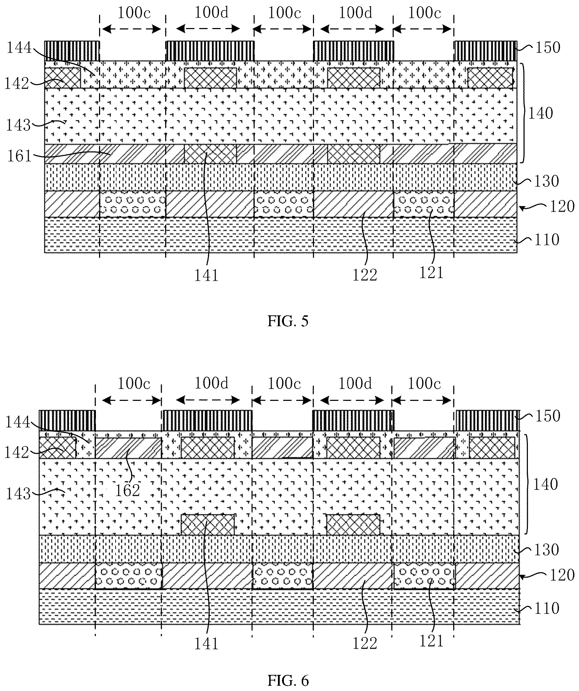

In some examples, as shown in FIGS. 2 to 4, there is a distance between the first color resistance 161 and the first touch control wire 141, so that it is possible to avoid mutual interference between the first color resistance 161 and the first touch control wire 141 during the preparation process due to process errors. In other examples, as shown in FIG. 5, a sidewall surface of the first color resistance 161 may be in contact with a sidewall surface of the first touch control wire 141, so that the surface of the side, facing away from the light-emitting layer 120, of the first color resistance 161 and the first touch control wire 141 is relatively complete. When the surface, facing away from the light-emitting layer 120, of the first color resistance 161 is flush with the surface, facing away from the light-emitting layer 120, of the first touch control wire 141, the flat surface is provided. In addition, when the size of the first color resistance 161 is larger, more light can pass through the first color resistance 161, which can better ensure the display angle and display brightness of the display panel 100 and the display apparatus.

As shown in FIG. 2, the first insulating layer 143 may be located on the side, facing away from the light-emitting layer 120, of the first touch control wire 141 and the first color resistance 161, so that the first insulating layer 143 and other structure layers on a side, facing away from the light-emitting layer 120, of the first insulating layer 143 can protect the first color resistance 161, and there is no need to provide a barrier layer for the first color resistance 161 separately, thereby simplifying the preparation processes of the display panel 100 and the display apparatus.

In some embodiments, as shown in FIG. 6, the plurality of color resistances may include a second color resistance 162, and the second color resistance 162 and the second touch control wire 142 are arranged in a same layer. The second color resistance 162 and the second touch control wire 142 may be located on a side, facing away from the light-emitting layer 120, of the first insulating layer 143.

The second color resistance 162 provided in the embodiments of the present application will be described below.

The second color resistance 162 includes a plurality of sub color resistances arranged in the same layer, and the plurality of sub color resistances may be second sub color resistances, the principle of which has been described and will not be repeated.

Exemplarily, a surface, facing the light-emitting side, of the second color resistance 162 may be flush with a surface, facing the light-emitting side, of the second touch control wire 142, or the surface, facing the light-emitting side, of the second color resistance 162 may be raised relative to the surface, facing the light-emitting side, of the second touch control wire 142. The principle thereof is similar to that of the first color resistance 161 and the first touch control wire 141, which will not be repeated here.

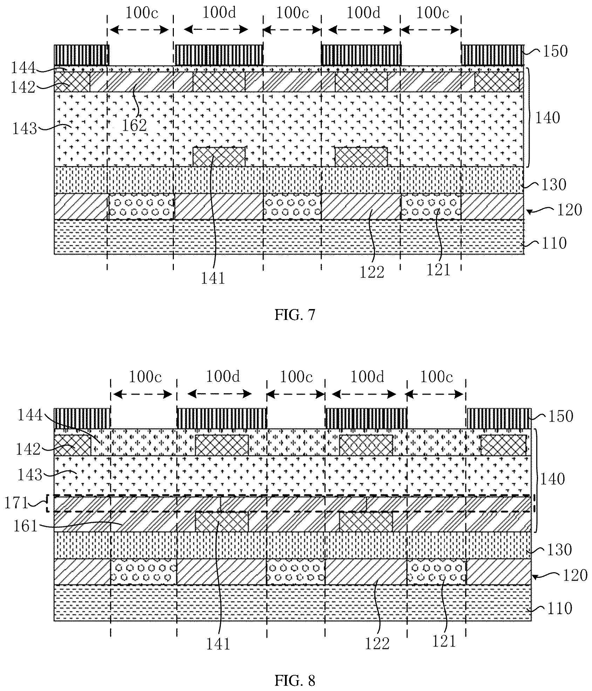

Exemplarily, as shown in FIG. 6, there may be a distance between the second color resistance 162 and the second touch control wire 142. Alternatively, as shown in FIG. 7, a sidewall surface of the second color resistance 162 may be in contact with a sidewall surface of the second touch control wire 142, and the principle thereof is similar to that of the first color resistance 161 and the first touch control wire 141, which will not be repeated here.

It should be noted that, the first color resistance 161 and the second color resistance 162 may be arranged separately, or may be arranged simultaneously.

In some embodiments, as shown in FIG. 8 to FIG. 10, the touch control layer 140 can also be provided with a first auxiliary color resistance 171, and the first auxiliary color resistance 171 is arranged in a different layer from the first touch control wire 141 and the first auxiliary color resistance 171 is arranged in a different layer from the second touch control wire 142. The first auxiliary color resistance 171 and the first touch control wire 141 are "arranged in different layers", which means that the first auxiliary color resistance 171 and the first touch control wire 141 are stacked in the thickness direction. The first auxiliary color resistance 171 and the first touch control wire 141 may be in contact or spaced apart along the thickness direction. The first auxiliary color resistance 171 and the second touch control wire 142 are "arranged in different layers", which means that the first auxiliary color resistance 171 and the second touch control wire 142 are stacked in the thickness direction. The first auxiliary color resistance 171 and the second touch control wire 142 may be in contact or spaced apart along the thickness direction. The principles of different-layer-arrangement in embodiments of the present application are similar, which will not be described hereafter.

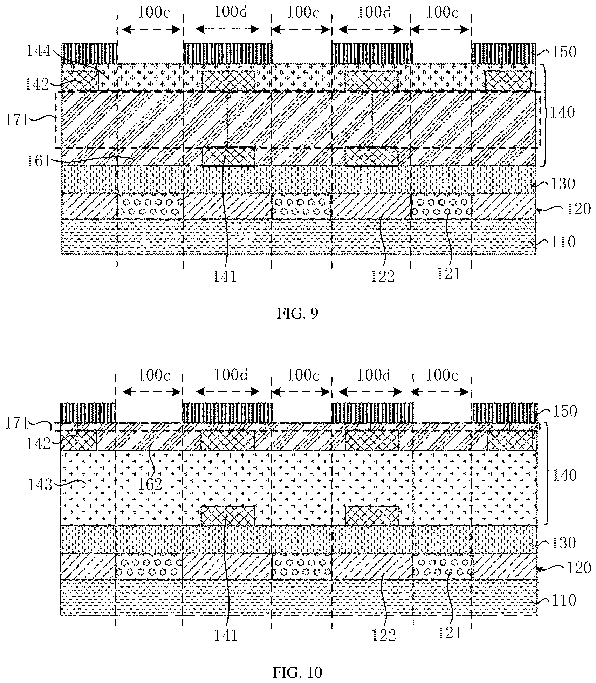

Exemplarily, as shown in FIG. 8 and FIG. 9, the first auxiliary color resistance 171 may be located on a surface, facing away from the light-emitting layer 120, on the side of the first touch control wire 141. If the first color resistance 161 is arranged concurrently, the first auxiliary color resistance 171 can also be located on a surface of a side, facing away from the light-emitting layer 120, of the first color resistance 161. That is, the first auxiliary color resistance 171 can cover the surface of the side, facing away from the light-emitting layer 120, of both the first touch control wire 141 and the first color resistance 161. For example, the surface of the side, facing away from the light-emitting layer 120, of the first auxiliary color resistance 171 may be flush, so as to provide a relatively flat support surface for the structure layers subsequently prepared thereon. Alternatively, the surface of the side, facing away from the light-emitting layer 120, of the layer auxiliary color resistance 171 may not be flush.

The first auxiliary color resistance 171 may include a first portion and a second portion, where the first portion is located on the surface of the side, facing away from the light-emitting layer 120, of the first color resistance 161, the second portion is located on the surface of the side, facing away from the light-emitting layer 120, of the first touch control wire 141, and the second portion is provided between two adjacent first portions. A color of the first portion is the same as that of the first color resistance 161, and the first portion and the first color resistance 161 may be prepared as a single piece. In addition, two first portions adjacent to a second portion may have two different colors including a first color and a second color. The second portion includes a first end and a second end, and the first end is close to the first portion of the first color. The color of the first end may be the first color, and the first end may be integrated with the adjacent first portion. The second end is close to the first portion of the second color, and the color of the second end may be the second color. The second end may be integrated with the adjacent first portion. Alternatively, the second portion may have the same color as one of the two adjacent first portions, and the second portion can be integrated with the first portion of the same color.

At this time, the first color resistance 161 and the first auxiliary color resistance 171 can cover the surface of the side, facing away from the light-emitting layer 120, of the first touch control wire 141 and the sidewall surface to form a good covering for the first touch control wire 141, so as to form better protection for the first touch control wire 141. The first insulating layer 143 may be replaced partially or integrally by the first auxiliary color resistance 171 and the first color resistance 161, which may facilitate lightening and thinning of the display panel 100 and the display apparatus.

Exemplarily, the first auxiliary color resistance 171 may be located on a surface of a side, facing the light-emitting layer 120, of the first touch control wire 141. If the first color resistance 161 is arranged concurrently,, the first auxiliary color resistance 171 may also be located on a surface of a side, facing the light-emitting layer 120, of the first color resistance 161. That is, the first auxiliary color resistance 171 may cover the surface of the side, facing the light-emitting layer 120, of both the first touch control wire 141 and the first color resistance 161. The first auxiliary color resistance 171 may include a first portion and a second portion, the first portion is located on the surface of the side, facing the light-emitting layer 120, of the first color resistance 161, and the second portion is located on the surface of the side, facing the light-emitting layer 120, of the first touch control wire 141. The principle thereof has been explained, and will not be repeated here. At this time, the first color resistance 161 and the first auxiliary color resistance 171 may cover the surface of the side, facing the light-emitting layer 120, of the first touch control wire 141 and the sidewall surface to form a good covering for the first touch control wire 141, so as to form better protection for the first touch control wire 141. In an embodiment where a buffer layer is provided, the buffer layer may be replaced by the first color resistance 161 and the first auxiliary color resistance 171 partially or integrally, thereby facilitating the lightening and thinning of the display panel 100 and the display apparatus.

It should be noted that, at least one side of opposite sides of the first touch control wire 141 along the thickness direction may be provided with the first auxiliary color resistance 171 in the above embodiments.

Exemplarily, as shown in FIG. 10, the first auxiliary color resistance 171 may be located on a surface of a side, facing away from the light-emitting layer 120, of the second touch control wire 142. At this time, the first auxiliary color resistance 171 and the second color resistance 162 can partially replace the second insulating layer 144, so as to form a better protection for the second touch control wire 142. In addition, the first auxiliary color resistance 171 may be located on a surface of a side, facing the light-emitting layer 120, of the second touch control wire 142. At this time, the first insulating layer 143 may be replaced by the first auxiliary color resistance 171 and the second color resistance 162 partially or integrally. The first auxiliary color resistance 171 may include a third portion and a fourth portion, the third portion covers the surface of the second color resistance 162, and the fourth portion covers the surface of the second touch control wire 142. The principle thereof is the same as that of the first portion and the second portion, which will not be repeated here.

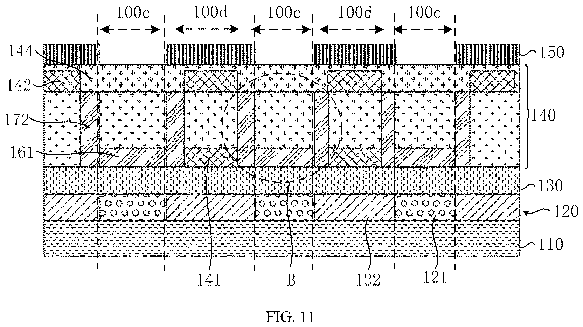

As shown in FIG. 11, a second auxiliary color resistance 172 may be arranged in the touch control layer 140, and the second auxiliary color resistance 172 is located on a side, facing the light-emitting area 100c, of the non-light-emitting area 100d. The second auxiliary color resistance 172 and the color resistance(s) adjacent thereto (including the first color resistance 161 and/or the second color resistance 162) are different in color.

In an area B of FIG. 11, it is taken as an example for illustration that the plurality of color resistances in the touch control layer 140 include a first color resistance 161. The second auxiliary color resistance 172 is arranged at a position close to an edge of the first color resistance 161 and a positional relationship between the second auxiliary color resistance 172 located at the position close to the edge of the first color resistance 161 and the first color resistance 161 may be regarded as "adjacent". That is, the positional relationship between the first color resistance 161 and the second auxiliary color resistance 172 in the area B as shown in FIG. 11 is regarded as "adjacent" in embodiments of the present application. For example, the pixel corresponding to the B area is a first color pixel, a second color pixel and a third color pixel may be arranged on both sides of the first color pixel. Light emitted by the first color pixel enters the area B through the first color resistance 161, and the color of the light is the first color. Since the second auxiliary color resistance 172 adjacent to the first color resistance 161 is different from the first color and the light of the first color cannot pass through the second auxiliary color resistance 172, light emitted by the first color pixel cannot pass through the second auxiliary color resistance 172, so as to avoid light mixing between adjacent pixels.

In some examples, in the area B, a color of a second auxiliary color resistance 172 close to the second color pixel may be the second color, so that only light of the second color can pass through, so as to avoid light mixing of adjacent pixels. In addition, a color of a second auxiliary color resistance 172 close to the third color pixel may be the third color, so that only light of the third color can pass through, so as to avoid light mixing of adjacent pixels. Alternatively, the color of the second auxiliary color resistance 172 close to the second color pixel and the color of the second auxiliary color resistance 172 close to the third color pixel may both be the second color or the third color, so that the two second auxiliary color resistances 172 may be prepared at the same time.

In some embodiments, the light filtering layer may include a light-shielding layer 150, and the light-shielding layer 150 may be formed of a material capable of blocking light and capable of absorbing light irradiated on the light-shielding layer 150.

The light-shielding layer 150 provided in the embodiments of the present application will be described below.

The light-shielding layer 150 is located on a side, facing the light-emitting side, of the touch control layer 140, and the light-shielding layer 150 is located on a side, facing away from the light-emitting layer 120, of the touch control layer 140. The light-shielding layer 150 may be located in the non-light-emitting area 100d, so as to avoid affecting a light-emitting rate of the display panel 100 by the light-shielding layer 150.

Exemplarily, as shown in FIG. 1, the light-shielding layer 150 includes a first light-shielding layer 151 and a second light-shielding layer 152, and the first light-shielding layer 151 is located in the non-light-emitting area 100d of the display area 100a. The second light-shielding layer 152 is located in the non-display area 100b. The first light-shielding layer 151 and the second light-shielding layer 152 may have a same parameter or different parameters, in terms of thickness, length, width and others; the first light-shielding layer 151 and the second light-shielding layer 152 may have an overlapping part in the thickness direction, or may be spaced apart in the thickness direction, which is not limited in the embodiments of the present application.

It should be noted that since the second light-shielding layer 152 is provided, and the second light-shielding layer 152 has a good light-shielding effect, an ink layer in the non-light-emitting area 100d may be omitted, thereby simplifying the preparation processes of the display panel. In addition, compared with the ink layer, the second light-shielding layer 152 has higher connection stability with other structure layers, thereby improving sealing performance of the display panel 100 and prolonging the service life of the display panel 100.

Exemplarily, in the display area 100a, an orthographic projection of the light-shielding layer 150 on a plane where the first touch control wire 141 is located may cover the first touch control wire 141, and an orthographic projection of the light-shielding layer 150 on the light-emitting layer 120 may cover an orthographic projection of the first touch control wire 141 on the light-emitting layer 120. That is, a size of the light-shielding layer 150 is greater than or equal to a size of the first touch control wire 141. Therefore, the reflection of ambient light on the first touch control wire 141 may be avoided, so as to improve the display effect of the display panel 100.

The plane where the first touch control wire 141 is located refers to a plane where the first touch control wire 141 is generally located, and length and width extending directions of the first touch control wire 141 are located on the plane.

Exemplarily, in the display area 100a, an orthographic projection of the light-shielding layer 150 on a plane where the second touch control wire 142 is located may cover the second touch control wire 142, and an orthographic projection of the light-shielding layer 150 on the light-emitting layer 120 may cover an orthographic projection of the second touch control wire 142 on the light-emitting layer 120. That is, the size of the light-shielding layer 150 is greater than or equal to a size of the second touch control wire 142. Therefore, the reflection of ambient light on the second touch control wire 142 can be avoided, so as to improve the display effect of the display panel 100.

In an embodiment in which a size of the color resistance is larger than that of the pixel, at least part of the plurality of color resistances (the first color resistance 161 and/or the second color resistance 162) extends to the non-emitting area 100d, and an orthographic projection of a color resistance located in the non-emitting area 100d on a plane where the light-shielding layer 150 is located overlaps at least partially with the light-shielding layer 150. At this time, an orthographic projection of the color resistance located in the non-light-emitting area 100d on the light-emitting layer 120 at least partially overlaps with an orthographic projection of the light-shielding layer 150 on the light-emitting layer 120. In this way, the color resistance has a relatively large area, so that more ambient light is irradiated on the color resistance, the filtering effect for ambient light is better, and the reflection of ambient light may be better reduced, thereby improving the display effect of the display panel 100. At this time, the light-shielding layer 150 overlaps with an edge of the color resistance, so that it may be avoided that a partial area between the light-shielding layer 150 and the color resistance is not covered by the light filtering layer due to deviation between the light-shielding layer 150 and an predetermined position due to a process error (high reflection will occur if not covered by the light filtering layer). Thus, the display effect of the display panel 100 may not be affected.

Exemplarily, as shown in FIG. 1, the light-shielding layer 150 is provided with a plurality of second openings 182 spaced apart, and an orthographic projection of the plurality of second openings 182 on the light-emitting layer 120 covers the pixel layer 121, so that an aperture ratio of the display panel 100 may not be affected by the light-shielding layer 150. A shape of the second opening 182 may be a circle, and of course, the shape of the second opening 182 may also be any one or more of an ellipse and a polygon (such as a quadrilateral, a pentagon, a hexagon, etc.). It has many choices and can be applied to many scenarios.

It should be noted here that the numerical values and numerical ranges involved in the embodiments of the present application are approximate values, and there may be errors in a certain range due to influence of the preparation process, and those skilled in the art can consider these errors to be ignored.

Finally, it should be noted that the above embodiments are only used to illustrate the technical solutions of the present application, but not to limit them; although the present application has been described in detail with reference to the foregoing embodiments, those of ordinary skill in the art should understand that: the technical solutions described in the foregoing embodiments can still be modified, or some or all of the technical features thereof can be equivalently replaced; and these modifications or replacements do not make the essence of the corresponding technical solutions deviate from the scope of the technical solutions of the embodiments of the present application.

## Claims

1. A display panel, provided with a light-emitting area and a non-light-emitting area, and a light-emitting side and a backlight side of the display panel oppositely arranged along a thickness direction of the display panel, comprising:
a touch control layer; and
a light filtering layer;
wherein the light filtering layer comprises a light-shielding layer and a plurality of color resistances, the plurality of color resistances are located in the touch control layer, at least part of the plurality of color resistances are located in the light-emitting area; and the light-shielding layer is located on a side, facing the light-emitting side, of the touch control layer and is located in the non-light-emitting area.

2. The display panel according to claim 1, wherein the touch control layer comprises a first touch control wire and a second touch control wire, and the second touch control wire is located on a side, facing the light-emitting side, of the first touch control wire.

3. The display panel according to claim 2, wherein an orthographic projection of the light-shielding layer on a plane in which the first touch control wire is located covers the first touch control wire.

4. The display panel according to claim 2, wherein an orthographic projection of the light-shielding layer on a plane in which the second touch control wire is located covers the second touch control wire.

5. The display panel according to claim 2, wherein at least part of the plurality of color resistances extend to the non-light-emitting area, and an orthographic projection of the color resistance located in the non-light-emitting area on a plane in which the light-shielding layer is located at least partially overlaps the light-shielding layer.

6. The display panel according to claim 2, wherein the plurality of color resistances comprise a first color resistance arranged in a same layer as the first touch control wire.

7. The display panel according to claim 6, wherein a surface, facing the light-emitting side, of the first color resistance is flush with or protrudes from a surface, facing the light-emitting side, of the first touch control wire.

8. The display panel of claim 6, further comprising an encapsulation layer located on a side, facing away from the light-shielding layer, of the touch control layer and contacted with the first color resistance.

9. The display panel according to claim 8, further comprising a light-emitting layer located on a side, facing away from the light-shielding layer, of the encapsulation layer, wherein the light-emitting layer comprises an anode layer, a pixel layer and a cathode layer sequentially stacked along the thickness direction, the anode layer is located on a side, facing away from the light-shielding layer, of the pixel layer, the pixel layer is located in the light-emitting area; the anode layer comprises a plurality of anodes, and the pixel layer comprises a plurality of pixels.

10. The display panel according to claim 9, wherein a shape of at least one of the anode and the pixel comprises a circle.

11. The display panel according to claim 9, wherein the light-emitting layer further comprises a pixel defining layer located between the anode layer and the cathode layer; the pixel defining layer is defined with a plurality of first openings, the plurality of pixels are located in the plurality of first openings; an orthographic projection of the pixel defining layer on a plane in which the plurality of anodes are located covers edges of the plurality of anodes, and a shape of the first opening comprises a circle.

12. The display panel according to claim 9, wherein the light-shielding layer is defined with a plurality of second openings, an orthographic projection of the plurality of second openings on the light-emitting layer covers the pixel layer, and a shape of the second opening comprises a circle.

13. The display panel according to any one of claims 2 to 12, wherein the plurality of color resistances comprise a second color resistance arranged in a same layer as the second touch control wire.

14. The display panel according to claim 13, wherein a surface, facing the light-emitting side, of the second color resistance is flush with or protrudes from a surface, facing the light-emitting side, of the second touch control wire.

15. The display panel according to any one of claims 2 to 12, further comprising a first auxiliary color resistance located in the touch control layer; wherein the first auxiliary color resistance and the first touch control wire are arranged in different layers, and the first auxiliary color resistance and the second touch control wire are arranged in different layers.

16. The display panel according to claim 15, wherein the first auxiliary color resistance is located on at least one of a surface, facing the light-emitting side, of the first touch control wire and a surface, facing the backlight side, of the first touch control wire.

17. The display panel according to claim 15, wherein the first auxiliary color resistance is located on at least one of a surface, facing the light-emitting side, of the second touch control wire and a surface, facing the backlight side, of the second touch control wire.

18. The display panel according to any one of claims 2 to 12, further comprising a second auxiliary color resistance located in the touch control layer, wherein the second auxiliary color resistance is located on a side, facing the light-emitting area, of the non-light-emitting area, and the second auxiliary color resistance has different color from a color resistance of the plurality of the color resistances adjacent thereto.

19. The display panel according to any one of claims 1 to 12, comprising a display area and a non-display area, wherein the light-emitting area and the non-light-emitting area are located in the display area;
the light-shielding layer comprises a first light-shielding layer and a second light-shielding layer, the first light-shielding layer is located in the display area, and the second light-shielding layer is located in the non-display area.

20. A display apparatus, comprising the display panel according to any one of claims 1 to 19.
